# EUROPEAN PATENT SPECIFICATION

(11) **EP 3 144 936 B1**
(45) Date of publication and mention of the grant of the patent: **25.09.2019**
(21) Application number: 16186090.3
(22) Date of filing: 29.08.2016
(51) Int. Cl.: G11C 5/00, G11C 11/412, H01L 23/552, G06F 11/10

(54) **SYSTEMS AND METHODS FOR PARTICLE DETECTION AND ERROR CORRECTION IN AN INTEGRATED CIRCUIT**
SYSTEME UND VERFAHREN ZUR PARTIKELDETEKTION UND FEHLERKORREKTUR IN EINER INTEGRIERTEN SCHALTUNG
SYSTEMES ET PROCEDES DE DETECTION DE PARTICULES ET DE CORRECTION D'ERREURS DANS UN CIRCUIT INTEGRE

(30) Priority: 18.09.2015 US 201514859097
(43) Date of publication of application: 22.03.2017
(73) Proprietor: Altera Corporation, San Jose, CA 95134 (US)
(72) Inventor: Gaspard, Nelson Jospeh, San Jose, California 95134 (US); Xu, Yanzhong, San Jose, California 95134 (US)
(74) Representative: Appelt, Christian W.

(56) References cited:
- US-A1- 2004 233 701
- US-A1- 2006 000 981
- US-A1- 2009 231 771
- US-A1- 2013 036 325
- US-A1- 2013 335 875
- US-A1- 2014 032 135
- US-B1- 7 036 059

## Description

### Background

A Single Event Upset (SEU) is a change in state or a transient voltage pulse at sensitive nodes in integrated circuits, such as processors. SEUs occur due to high energy particle strikes on the silicon substrate of processors. Errors can occur due to an SEU if it leads to a state flip in the sequential storage elements that determine the architectural state of the processor, such as the random access memory (RAM) arrays, the Register File and the architectural-state registers. An SEU can cause the affected integrated circuit to malfunction. Integrated circuits tend to become more susceptible to SEUs as integrated circuit feature sizes decrease, which is one of the more important trends in integrated circuit fabrication.

Generally, error detection cyclic redundancy checking (EDCRC) and scrubbing circuitry is used to perform SEU detection and correction in an integrated circuit. However, such circuitry requires complex detection circuitry and power to perform the SEU detection. It also takes a long time to detect the SEUs since the EDCRC and scrubbing circuitry needs to scan the entire IC for errors. This causes the EDCRC and scrubbing circuitry to be constantly running on the IC, which may result in higher power consumption and voltage supply noises.

US 2006/0000981 A1 relates to a cosmic ray detector that includes a cantilever with a first tip. The detector also includes a second tip and circuitry to provide a signal indicative of a distance between the first and second tips being such as would be caused by a cosmic ray interaction event.

US 2014/0032135 A1 discloses a system to ensure correct operation of a semiconductor chip in the presence of ionizing radiation. The system includes a semiconductor chip, a first radiation detection array incorporated in the semiconductor chip, and at least one additional radiation detection array incorporated in the semiconductor chip. A processor determines a region of the semiconductor chip affected by an incident radiation particle by analyzing a trajectory of the radiation particle determined from locations of sensors hit by the radiation particle in the first radiation detection array and the at least one additional radiation detection array. The processor determines whether corrective action is needed based on the region of the semiconductor chip affected by the incident radiation particle.

### Summary

In accordance with the present invention, systems and methods are provided for particle detection and corresponding error correction in an integrated circuit. The invention is defined by the subject matter of the independent claims. Advantageous embodiments are subject to the dependent claims and are outlined herein below.

An integrated circuit having a substrate and logic circuit that includes a group of transistors formed at a surface of the substrate is disclosed. The integrated circuit includes particle sensing circuit formed below at least one transistor of the group of transistors. The particle sensing circuit detects a cosmic particle that passes through the logic circuit. The particle sensing circuit includes a diode circuit that collects charges generated by the cosmic particle.

The integrated circuit further includes a particle validation circuit that generates an error detection signal in response to detecting the cosmic particle with the particle sensing circuit. The error detection signal may indicate that an error has occurred in the integrated circuit. The diode circuit is implanted in the substrate below an N-well region of the at least one transistor and within a P-type implant region in the substrate that surrounds the N-well region. The diode circuit is configured to collect a charge generated a cosmic particle that passes through the logic circuitry in said N-well region of said at least one transistor.

A method of operating an integrated circuit according to the invention is also provided. The method includes, with a diode circuit of particle sensing circuit formed within a substrate below at least one transistor of the plurality of transistors embedded below the substrate surface of the integrated circuit, detecting charge generated by a particle passing through the integrated circuit in said N-well

region (305) of said at least one transistor. The method further includes correcting an error event in the integrated circuit by determining whether a voltage perturbation associated with the detected stray charge using monitoring circuit connected to the particle sensing circuit. The monitoring circuit may selectively correct the error events based on the identified particle energy.

Further features of the invention, its nature and various advantages will be more apparent from the accompanying drawings and the following detailed description of the preferred embodiments.

### Brief Description of the Drawings

FIG. 1 is a diagram of an illustrative integrated circuit in accordance with an embodiment of the present invention.
FIG. 2 is a top view diagram of an illustrative integrated circuit having multiple transistor strips in accordance with an embodiment of the present invention.
FIG. 3 is a cross section diagram of an illustrative integrated circuit region of an integrated circuit in accordance with an embodiment of the present invention.
FIG. 4 is an illustrative circuit of an integrated circuit having error detection circuitry in accordance with an embodiment of the present invention.
FIG. 5 is a flow chart of illustrative steps for detecting and correcting error event in an integrated circuit in accordance with an embodiment of the present invention.

### Detailed Description

The embodiments provided herein include systems and methods for atomic particle detection and error correction in an integrated circuit.

It will be obvious, however, to one skilled in the art, that the present exemplary embodiments may be practiced without some or all of these specific details. In other instances, well-known operations have not been described in detail in order not to obscure unnecessarily the present embodiments.

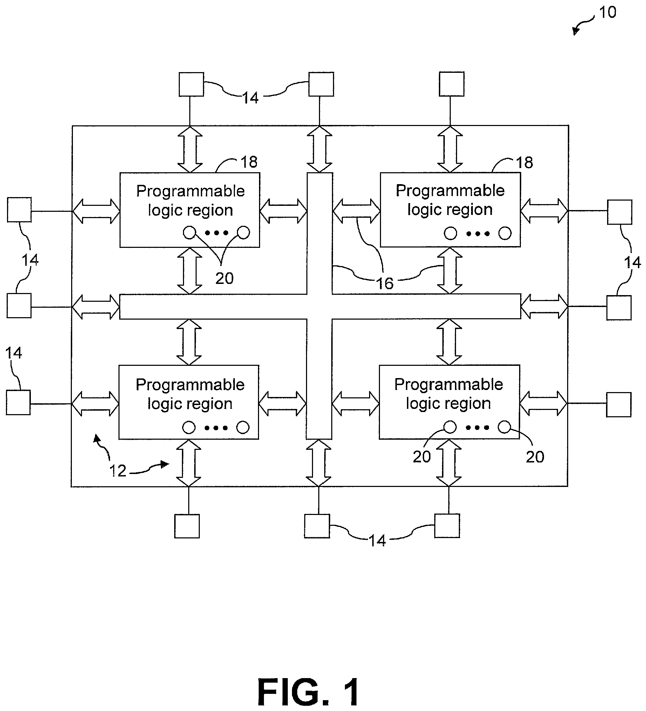

FIG. 1 is a diagram of an illustrative integrated circuit 10 in accordance with an embodiment of the present invention. Integrated circuit 10 has input-output (10) circuitry 12 for driving signals off of integrated circuit 10 and for receiving signals from other circuits or devices via IO pins 14. Interconnection resources 16 such as global and local vertical and horizontal conductive lines and busses may be used to route signals on integrated circuit 10. Interconnection resources 16 include fixed interconnects (conductive lines) and programmable interconnects (e.g., programmable connections between respective fixed interconnects). The programmable interconnects associated with interconnection resources 16 may be considered to be a part of programmable logic regions 18.

Integrated circuit 10 contains volatile memory elements 20 that can be loaded with configuration data (also called programming data) using IO pins 14 and IO circuitry 12. Once loaded, the memory elements each provide a corresponding static control output signal that controls the state of an associated logic component in programmable logic 18. If desired, memory elements 20 may be used in SRAM-type memory arrays (e.g., to store data for processing circuitry during operation of integrated circuit 10).

Each memory element 20 may be formed from a number of transistors configured to form a bistable circuit. With one suitable approach, complementary metal-oxide-semiconductor (CMOS) integrated circuit technology is used to form the memory elements 20, so CMOS-based memory element implementations are described herein as an example. If desired, other integrated circuit technologies may be used to form the memory elements and the integrated circuit in which the memory elements are used to form memory arrays.

The memory elements may be loaded from an external erasable-programmable read-only memory and control chip or other suitable data source via IO pins 14 and IO circuitry 12. Loaded CRAM memory elements 20 may provide static control signals that are applied to the terminals (e.g., gates) of circuit elements (e.g., metal-oxide-semiconductor transistors) in programmable logic 18 to control those elements (e.g., to turn certain transistors on or off) and thereby configure the logic in programmable logic 18. The circuit elements may be transistors such as pass transistors, parts of multiplexers, look-up tables, logic arrays, AND, OR, NAND, and NOR logic gates, etc.

The memory elements 20 may be arranged in an array pattern. During programming operations, the array of memory elements may be provided with configuration data by a user (e.g., a logic designer). Once loaded with configuration data, the memory elements 20 selectively control portions of the circuitry in the programmable logic 18 and thereby customize its functions so that it will operate as desired.

The circuitry of integrated circuit 10 may be organized using any suitable architecture. As an example, the logic of integrated circuit 10 may be organized in a series of rows and columns of larger programmable logic regions each of which contains multiple smaller logic regions. The logic resources of integrated circuit 10 may be interconnected by interconnection resources 16 such as associated vertical and horizontal conductors. These conductors may include global conductive lines that span substantially all of integrated circuit 10, fractional lines such as half-lines or quarter lines that span part of integrated circuit 10, staggered lines of a particular length (e.g., sufficient to interconnect several logic areas), smaller local lines, or any other suitable interconnection resource arrangement. If desired, the logic of integrated circuit 10 may be arranged in more levels or layers in which multiple large regions are interconnected to form still larger portions of logic. Still other device arrangements may use logic that is not arranged in rows and columns.

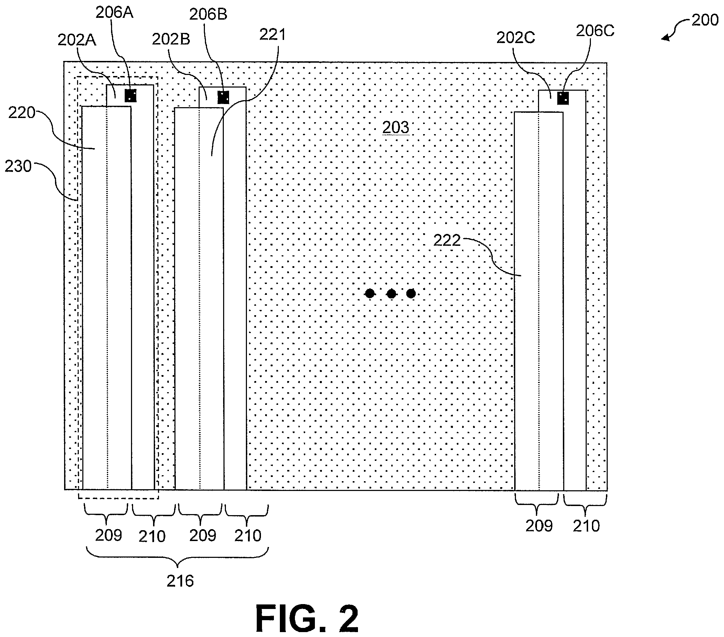

When memory elements 20 are arranged in an array, horizontal and vertical conductors and associated loading circuitry may be used to load the memory elements with configuration data. Any suitable memory array architecture may be used to load an array of memory elements 20. One suitable arrangement is shown in FIG. 2. FIG. 2 is a top view diagram of integrated circuit 200 having multiple transistor strips in accordance with an embodiment of the present invention. Integrated circuit 200 includes multiple strips (or columns) of transistors (e.g., transistor strips 220, 221, and 222) formed on a semiconductor substrate (e.g., substrate 203). For the purpose of simplifying the description of an example of the invention, only three transistor strips (e.g., transistor strips 220, 221, and 222) are shown in FIG. 2. Transistor strips 220, 221, and 222 may be part of an array of memory elements 20 of FIG. 1. It should be noted that a typical memory array might, as an example, have thousands or millions of memory elements 20 arranged in hundreds or thousands or rows and columns. N-type well regions (e.g., N-well regions 209) and P-type well regions (e.g., P-well regions 210) may be placed so that they are directly abutting active devices such as transistors (not shown) within each transistor strip.

Memory cells that include memory elements such as memory elements 20 are prone to errors such as single event upsets (SEUs) that are sometimes also referred to as soft errors. An SEU occurs when a charged particle causes a transient voltage spike, which results in a change of state of the memory element. The charged particle may be due to natural radiation that is present in substrate of the integrated circuit and die packaging or generated in the substrate by cosmic rays or other atomic particles (e.g., alpha particles, neutron, and protons). One of the ways to detect the charged particle in the integrated circuit is by forming a particle sensing circuit (e.g., particle sensing circuits 202A, 202B, and 202C) under each transistor strip. As shown in FIG. 2, particle sensing circuits 202A, 202B, and 202C are illustrated as blanket implants or stripes formed near the surface of substrate 203. Particle sensing circuits 202A, 202B, and 202C may be extended along and below N-well regions 209 of transistor strips 220, 221, and 222, respectively. In one embodiment, particle sensing circuits 202A, 202B, and 202C may collect particle charge deposited by the charged particle within the respective transistor strips 220, 221, and 222. For example, particle sensing circuits 202A, 202B, and 202C may be diode circuits. In another embodiment, the use of multiple particle sensing circuits in integrated circuit 200 may allow the location of the particle strike to be identified.

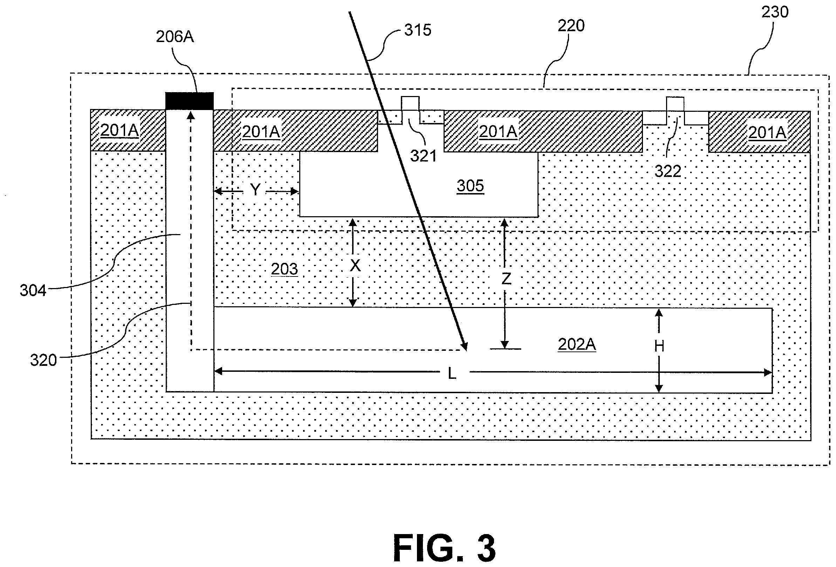

Accordingly, each particle sensing circuit 202A, 202B, and 202C may be connected to a corresponding particle validation circuit (e.g., particle validation circuits 206A, 206B, and 206C). In one embodiment, a particle validation circuit may sense the particle charge collected by a particle sensing circuit and generate an error detection signal that triggers error correction operations in integrated circuit 200. For example, particle validation circuits 206A, 206B, 206C may be sensor circuits. A more detailed description of transistor strip 220, particle sensing circuit 202A, and particle validation circuit 206A is described below with reference to integrated circuit region 230 of FIG. 3.

FIG. 3 is a cross sectional diagram of an illustrative integrated circuit region 230 of integrated circuit 200 of FIG. 2 (e.g., with a more detailed representation of transistor strip 220, particle sensing circuit 202A, and particle validation circuit 206A). As shown, a strip of transistors (e.g., transistor strip 220) is formed in substrate 203. In one embodiment, a combination of N-channel metal oxide semiconductor (NMOS) and P-channel metal oxide semiconductor (PMOS) transistors may be present in transistor strip 220. As an example, one PMOS transistor (e.g., transistor 321) may be formed in an N-type well region (e.g., N-well 305), and one NMOS transistor (e.g., transistor 322) may be formed in a P-type well region (not shown in FIG. 3 but represented by P-well 210 of FIG. 2, for example). In practice there may be one or more additional N-wells and P-wells. Further, there may be many (e.g., tens, hundreds, or thousands) of transistors formed in each well. To prevent electrical current leaking between adjacent transistors 321 and 322, shallow trench isolation (STI) region 201A may be formed on the surface of substrate 203 to isolate transistors 321 and 322 from each other.

As shown, transistors 321 and 322 may be subjected to an atomic particle (e.g., cosmic particle) strike, as indicated by arrow 315. The atomic particle may interfere with charges held within sensitive nodes of the transistors in the integrated circuit, thereby affecting the corresponding logic states. When high energy atomic particles strike a sensitive node region, the particles can cause a bit in the memory cell to change states or flip. These soft errors, which are also known as single event upsets (SEUs), generally affect storage elements, such as memory, latches and registers.

In order to detect the occurrence and location of the atomic particle strike (or single event) in the integrated circuit, a stray charge of the atomic particle may be collected and analyzed. To do so, a particle sensing circuit may be formed near the sensitive nodes of the transistors to collect the charge deposited by the atomic particle. As shown, particle sensing circuit 202A of height H is implanted below N-well 305 of a depth Z in substrate 203. In one embodiment, depth Z may correspond to a peak doping depth. Depth Z may be, for example, about 1.5 µm. Height H may be, for example, about 1 micrometer (µm). Particle sensing circuit 202A may also extend substantially in a horizontal plane in substrate 203, from N-well 305 of transistor 321 to the P-well region (not shown) of transistor 322. In one example, particle sensing circuit 202A may be a diode circuit.

To ensure that the atomic particle charge is electrically isolated from interfering signals (e.g., switching noises) in other wells, P-type implant regions may be formed surrounding N-well 305. A P-type implant region is represented by substrate 203 in FIG. 3. For example, a P-type implant region of height X is created between the bottom surface of N-well region 305 and the top surface of particle sensing circuitry 202A. Height X may be, for example, 1 µm. Accordingly, another P-type implant region of width Y may be created between boundaries of N-well 305 and conductive via 304. Width Y may be, for example, 1 µm. The configuration of the P-type implant regions also ensures that no electrical conductivity is present within substrate 203.

In one embodiment, the size of the particle sensing circuit may influence a detectable voltage perturbation from deposited charge of the atomic particle due to junction capacitance (i.e., capacitive effect at a junction of the particle sensing circuit). Larger particle sensing circuits may have greater junction capacitance than smaller particle sensing circuits, which may lead to smaller voltage perturbations from an atomic particle strike than when smaller particle sensing circuits are used. In an exemplary embodiment, to detect a neutron particle, a particle sensing circuit having a size of, for example, 1 µm in both width and height (denoted by H) and 13 millimeters (mm) in length (denoted by L), will have a voltage perturbation of about 30 millivolts (mV). In contrast, a particle sensing circuit having a size of, for example, 1 µm in both width and height (denoted by H) and 1 millimeters (mm) in length (denoted by L), will have a voltage perturbation of about 360 mV.

In another exemplary embodiment, to detect an alpha particle, a particle sensing circuit having a size of, for example, 1 µm in both width and height (denoted by H) and 0.04 millimeters (mm) in length (denoted by L), will have a voltage perturbation of about 30 millivolts (mV). In contrast, a particle sensing circuit having a size of, for example, 1 µm in both width and height (denoted by H) and 0.01 millimeters (mm) in length (denoted by L), will have a voltage perturbation of about 110 mV.

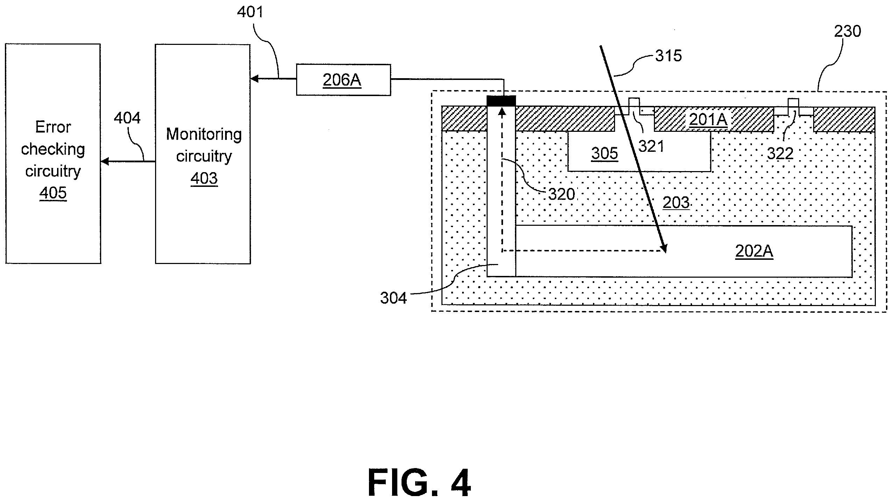

The voltage perturbation from the deposited charge of the atomic particle can be detected by particle sensing circuit 202A as indicated by arrow 320. For example, particle validation circuit 206A may include a sensor circuit, such as a sense amplifier. Particle validation circuit 206A may generate an output signal (which may also be referred to as a sensor output), which is described later in FIG. 4, based on the collected charges. The resultant output signal may trigger error correction operations associated with the atomic particle strike in the integrated circuit.

FIG. 4 is an illustrative integrated circuit having error detection circuitry in accordance with an embodiment of the present invention. The integrated circuit may be similar to integrated circuit 200 of FIG. 2. For the purpose of simplifying the description of the present invention, only a portion (e.g., integrated circuit region 230 of FIGS. 2 and 3) of the integrated circuit 200 is illustrated. Discussion of components already shown in integrated circuit region 230 (e.g., substrate 203, transistors 321 and 322, N-well 305, substrate 203, conductive via 304, and shallow trench isolation (STI) region 201A) and described above will not be repeated.

As shown in FIG. 4, the error detection circuitry includes a particle sensing circuit (e.g., particle sensing circuit 202A) coupled to an associated particle validation circuit (e.g., particle validation circuit 206A). Particle sensing circuit 202A and particle validation circuit 206A may collectively detect soft error events caused by atomic particle strikes that occur in the integrated circuit. Generally, the soft error events ("single event upsets" or SEUs) occur when a high-energy atomic particle strikes the critical circuitry (e.g., transistors 321 and 322 of FIG. 3) in an integrated circuit. A resulting transient voltage spike may be generated, which may cause a change of state (e.g., flipping of bits) of storage elements, such as memory elements 20 of FIG. 1, in the integrated circuit.

Because transistors 321 and 322 can be potentially struck by a high-energy atomic particle, particle sensing circuit 202A may be provided in substrate 203 to detect the particle strike. As an example, assume that a particle strike occurs within transistor strip 210 (as indicated by arrow 315). A stray charge produced by the atomic particle may be deposited within sensitive nodes (e.g., N-well 305 of transistor 321) of transistor strip 210. In this scenario, particle sensing circuit 202A, which is implanted below transistors 321 and 322 in substrate 203, may collect the deposited charge from N-well 305.

Accordingly, particle validation circuit 206A may validate the collected charge from particle sensing circuit 202A by detecting a voltage perturbation from the deposited charge of the atomic particle as indicated by arrow 320. It should be appreciated that particle validation circuit 206A may be implemented either internally or externally to integrated circuit 200 of FIG. 2. For clarity and ease of illustration, particle validation circuit 206A is depicted outside of integrated circuit region 230. A resultant voltage perturbation output (e.g., output signal 401) may be generated by particle validation circuit 206A based on the detected voltage perturbation from the collected charge. In one embodiment, the voltage perturbation output may represent particle energy of the atomic particle that strikes the sensitive nodes in the integrated circuit. Subsequently, output signal 401 is transmitted to monitoring circuitry 403.

In one embodiment, monitoring circuitry 403 may monitor a status of output signal 401 to identify a particle energy associated with the atomic particle and to identify error events in the integrated circuit. For example, monitoring circuitry 403 may include a polling circuit. In an embodiment, monitoring circuitry 403 may poll output signal 401 to determine whether a predetermined metric has changed, for example by comparing voltage perturbation output (e.g., output signal 401) to a predetermined voltage threshold. When the voltage perturbation output exceeds a predetermined threshold value, monitoring circuit 403 may generate an error correction signal (e.g., error correction signal 404) to error checking circuitry 405.

In general, error checking circuitry 405 may perform error detection and correction operations on the configuration RAM (CRAM) cells (e.g., memory elements 20 of FIG. 1) on integrated circuit 200 for soft errors (i.e., bit flips). For example, error checking circuitry 405 may include error detection cyclic redundancy checking (EDCRC) and scrubbing circuitry. In accordance with an embodiment of the invention, the operational frequency of error checking circuitry 405 can be reduced or turned off prior to the detection of atomic particle charge so as to reduce power consumption and voltage supply noises in the integrated circuit. Error checking circuitry 405 can be activated by error correction signal 404 to perform error correction operations on error events associated with the atomic particle strike in the integrated circuit.

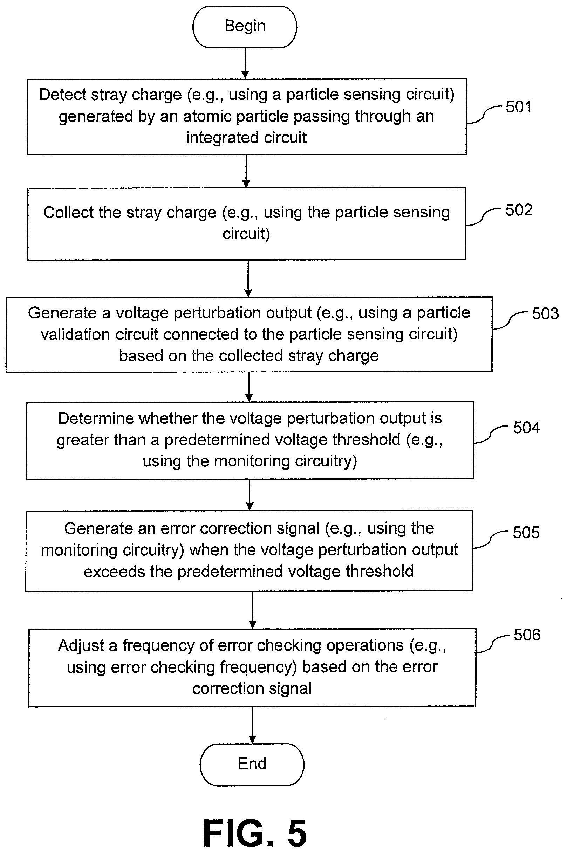

Illustrative steps involved in detecting and correcting soft error effects on an integrated circuit are shown in FIG. 5. It should be noted that FIGS. 3 and 4 will be used as exemplary embodiments to describe the present invention below.

During an atomic particle strike (as indicated by arrow 315 of FIGS. 3 and 4), the atomic particle may deposit a stray charge within the sensitive nodes in the integrated circuit (e.g., integrated circuit 200 of FIG. 2). At step 501, the stray charge can be detected using a particle sensing circuit (e.g., particle sensing circuit 202A of FIG. 2). For example, the particle sensing circuit may be a diode circuit. In one embodiment, multiple particle sensing circuits (e.g., particle sensing circuits 202B and 202C of FIG. 2) can be used to identify a location of the atomic particle strike in the integrated circuit.

The deposited stray charge of the atomic particle is then collected by the particle sensing circuit at step 502. A particle validation circuit (e.g., particle validation circuit 206A of FIGS. 3 and 4) connected to the particle sensing circuit may detect a voltage perturbation based on the collected charge and subsequently generate a voltage perturbation output at step 503. In one embodiment, the voltage perturbation output (e.g., output signal 401 of FIG. 4) is indicative of the particle energy of the atomic particle that strikes the integrated circuit.

At step 504, it is determined whether the voltage perturbation output is greater than a predetermined voltage threshold using the monitoring circuitry. As shown in FIG. 4, monitoring circuitry 403 may poll the voltage perturbation output (e.g., output signal 401) to determine whether a predetermined metric has changed. The polling may be conducted by comparing voltage perturbation output (e.g., output signal 401) to a predetermined voltage threshold. When the voltage perturbation output exceeds a predetermined threshold value, monitoring circuit 403 may generate an error correction signal (e.g., error correction signal 404) at step 505.

At step 506, a frequency of error checking operations is adjusted using error checking circuitry (e.g., error checking circuitry 405 of FIG. 4) based on the error correction signal. In one embodiment, the operational frequency of the error checking circuitry can be reduced or turned off prior to the detection of the stray charge generated by the atomic particle so as to reduce power consumption and voltage supply noises in the integrated circuit. The error checking circuitry can be activated by the error correction signal to perform error correction operations on error events associated with the atomic particle strike in the integrated circuit.

The methods and apparatus described herein may be incorporated into any suitable circuit. For example, the methods and apparatus may be incorporated into numerous types of devices such as microprocessors or other integrated circuits. Exemplary integrated circuits include programmable array logic (PAL), programmable logic arrays (PLAs), field programmable logic arrays (FPLAs), electrically programmable logic devices (EPLDs), electrically erasable programmable logic devices (EEPLDs), logic cell arrays (LCAs), field programmable gate arrays (FPGAs), application specific standard products (ASSPs), application specific integrated circuits (ASICs), just to name a few.

The programmable logic device described in one or more embodiments herein may be part of a data processing system that includes one or more of the following components: a processor; memory; IO circuitry; and peripheral devices. The data processing system can be used in a wide variety of applications, such as computer networking, data networking, instrumentation, video processing, digital signal processing, or any suitable other application where the advantage of using programmable or re-programmable logic is desirable. The programmable logic device can be used to perform a variety of different logic functions. For example, the programmable logic device can be configured as a processor or controller that works in cooperation with a system processor. The programmable logic device may also be used as an arbiter for arbitrating access to a shared resource in the data processing system. In yet another example, the programmable logic device can be configured as an interface between a processor and one of the other components in the system. In one embodiment, the programmable logic device may be one of the family of devices owned by the assignee.

Although the method operations were described in a specific order, it should be understood that other operations may be performed in between described operations, described operations may be adjusted so that they occur at slightly different times or described operations may be distributed in a system which allows the occurrence of the processing operations at various intervals associated with the processing, as long as the processing of the overlay operations are performed in a desired way.

## Claims

1. An integrated circuit (10, 200) comprising:
a substrate (203);
logic circuitry (18) that includes a plurality of transistors (220, 221, 222; 321, 322) formed at a surface of the substrate (203),
a particle sensing circuit (202A, 202B, 202C) comprising a diode circuit and formed within the substrate (203) below at least one transistor (321) of the plurality of transistors (220, 221, 222; 321, 322); and
a particle validation circuit (206A, 206B, 206C) configured to generate a detection signal in response to detecting the cosmic particle with the particle sensing circuit (202A, 202B, 202C);
**characterized in that**
the diode circuit is implanted in the substrate (203) below an N-well region (305) of said at least one transistor (321) and within a P-type implant region (210) in the substrate (203) that surrounds the N-well region (305), and
wherein the diode circuit is configured to collect a charge generated by a cosmic particle that passes through the logic circuitry (18) in said N-well region (305) of said at least one transistor (321).

2. The integrated circuit (10, 200) defined in claim 1, wherein the particle sensing circuit (202A, 202B, 202C) is formed at a depth of about 1 micrometer to 1.5 micrometer from an N-well region (305).

3. The integrated circuit (10, 200) defined in claim 1 or 2, wherein the detection signal is an error detection signal.

4. The integrated circuit (10, 200) defined in one of claim 1 to 3, wherein the particle sensing circuit (202A, 202B, 202C) is electrically coupled to the particle validation circuits (206A, 206B, 206C) through a conductive via (304).

5. The integrated circuit (10, 200) defined in one of claim 1 to 4, wherein the particle sensing circuit (202A, 202B, 202C) has a size, in a cross section of the integrated circuit (10), of 1 µm in height in a vertical direction, 13 millimeters in length in a horizontal direction, and 1 µm in width in a direction perpendicular to the vertical direction and horizontal direction.

6. The integrated circuit (10, 200) defined in one of claim 1 to 4, wherein the particle sensing circuit (202A, 202B, 202C) has a size, in a cross section of the integrated circuit (10), of 1 µm in height in a vertical direction, 0.04 millimeters in length in a horizontal direction, and 1 µm in width in a direction perpendicular to the vertical direction and horizontal direction.

7. The integrated circuit (10, 200) defined in one of claim 1 to 6, wherein the particle validation circuits (206A, 206B, 206C) comprises a sense amplifier.

8. The integrated circuit (10, 200) defined in in one of claims 1 to 7, wherein the particle sensing circuit (202A, 202B, 202C) is one of a plurality of particle sensing circuits (202A, 202B, 202C), each of which is arranged to detect a location of the cosmic particle within the integrated circuit (10, 200).

9. The integrated circuit (10, 200) defined in claim 8, wherein the particle validation circuits (206A, 206B, 206C) is one of a plurality of particle validation circuits (206A, 206B, 206C), wherein each of the plurality of particle validation circuits (206A, 206B, 206C) is coupled to a corresponding one of the plurality of particle sensing circuits (202A, 202B, 202C) through a corresponding conductive via (304).

10. A method for operating an integrated circuit (10, 200) according to one of claims 1 to 9, the method comprising the steps of:
with a diode circuit of particle sensing circuit (202A, 202B, 202C) formed within a substrate (203) below at least one transistor (321) of the plurality of transistors (220, 221, 222; 321, 322) of the integrated circuit (10, 200), detecting a charge generated by a particle passing through the integrated circuit (10, 200) in said N-well region (305) of said at least one transistor (321); and
with monitoring circuitry coupled to the particle sensing circuit (202A, 202B, 202C), correcting an error event in the integrated circuit (10, 200) by determining whether a voltage perturbation associated with the charge detected by the particle sensing circuit (202A, 202B, 202C) is greater than a predetermined voltage threshold.

11. The method defined in claim 10, further comprising the step of:
with the particle sensing circuit (202A, 202B, 202C), collecting the charge generated by the particle and passing the collected charge to the monitoring circuitry.

12. The method defined in claim 11, further comprising the step of:
with a sensor circuit (206A) coupled to the particle sensing circuit (202A, 202B, 202C), generating a voltage perturbation output based on the charge collected by the particle sensing circuit (202A, 202B, 202C) from the particle.

13. The method defined in claim 12, further comprising the steps of:
with the monitoring circuit (403), receiving the voltage perturbation output; and
with the monitoring circuit (403), comparing the voltage perturbation output to the predetermined voltage threshold.

14. The method defined in claim 13, further comprising the step of:
with the monitoring circuit (403), generating an error correction signal when the voltage perturbation output exceeds the predetermined voltage threshold.

15. The method defined in claim 14, further comprising the steps of:
with error checking circuit (405), receiving the error correction signal;
with the error checking circuit (405), activating at least one error correction operation in the integrated circuit (10, 200) based on the error correction signal; and
with the error checking circuit (405), reducing a frequency of the at least one error checking operation prior to detecting the charge generated by the particle passing through the integrated circuit (10, 200).

## Patentansprüche

1. Integrierter Schaltkreise (10, 200), umfassend:
ein Substrat (203);
einen Logikschaltung (18), die eine Vielzahl von Transistoren (220, 221, 222; 321, 322) aufweist, die auf einer Oberfläche des Substrats (203) gebildet sind,
einen Teilchenerfassungsschaltkreis (202A, 202B, 202C), der einen Diodenschaltkreis umfasst und in dem Substrat (203) unter mindestens einem Transistor (321) aus der Vielzahl von Transistoren (220, 221, 222; 321, 322) gebildet ist; und
einen Teilchenvalidierungsschaltkreis (206A, 206B, 206C) der konfiguriert ist zum Erzeugen eines Erkennungssignals als Reaktion auf das Erkennen des kosmischen Teilchens mit dem Teilchenerfassungsschaltkreis (202A, 202B, 202C);
**dadurch gekennzeichnet, dass**
der Diodenschaltkreis unter einem N-Wannengebiet (305) des mindestens einen Transistors (321) in das Substrat (203) und in ein P-Typ-Implantiergebiet (210) in das Substrat (203) implantiert ist, welches das N-Wannengebiet (305) umgibt, und
wobei der Diodenschaltkreis konfiguriert ist zum Aufnehmen einer Ladung, die durch ein kosmisches Teilchen erzeugt wird, das die Logikschaltung (18) in dem N-Wannengebiet (305) des mindestens einen Transistors (321) durchquert.

2. Integrierter Schaltkreis (10, 200) nach Anspruch 1, wobei der Teilchenerfassungsschaltkreis (202A, 202B, 202C) in einer Tiefe von ungefähr 1 µm bis 1,5 µm von einem N-Wannengebiet (305) gebildet ist.

3. Integrierter Schaltkreis (10, 200) nach Anspruch 1 oder 2, wobei das Erkennungssignal ein Fehlererkennungssignal ist.

4. Integrierter Schaltkreis (10, 200) nach einem der Ansprüche 1 bis 3, wobei der Teilchenerfassungsschaltkreis (202A, 202B, 202C) durch eine leitfähige Durchkontaktierung (304) mit den Teilchenvalidierungsschaltkreisen (206A, 206B, 206C) elektrisch verbunden ist.

5. Integrierter Schaltkreis (10, 200) nach einem der Ansprüche 1 bis 4, wobei der Teilchenerfassungsschaltkreis (202A, 202B, 202C) eine Größe in einem Querschnitt des integrierten Schaltkreises (10) aufweist, die in der Höhe in einer vertikalen Richtung 1 µm beträgt, in einer Länge in einer horizontalen Richtung 13 mm beträgt und in einer Breite in einer Richtung senkrecht zur vertikalen Richtung und zur horizontalen Richtung 1 µm beträgt.

6. Integrierter Schaltkreis (10, 200) nach einem der Ansprüche 1 bis 4, wobei der Teilchenerfassungsschaltkreis (202A, 202B, 202C) eine Größe in einem Querschnitt des integrierten Schaltkreises (10) aufweist, die in der Höhe in einer vertikalen Richtung 1 µm beträgt, in einer Länge in einer horizontalen Richtung 0,04 mm beträgt und in einer Breite in einer Richtung senkrecht zur vertikalen Richtung und zur horizontalen Richtung 1 µm beträgt.

7. Integrierter Schaltkreis (10, 200) nach einem der Ansprüche 1 bis 6, wobei die Teilchenvalidierungsschaltkreise (206A, 206B, 206C) einen Erfassungsverstärker umfasst.

8. Integrierter Schaltkreis (10, 200) nach einem der Ansprüche 1 bis 7, wobei der Teilchenerfassungsschaltkreis (202A, 202B, 202C) einer aus einer Vielzahl von Teilchenerfassungsschaltkreisen (202A, 202B, 202C) ist, die alle geeignet sind zum Erkennen eines Orts des kosmischen Teilchens innerhalb des integrierten Schaltkreises (10, 200).

9. Integrierter Schaltkreis (10, 200) nach Anspruch 8, wobei die Teilchenvalidierungsschaltkreise (206A, 206B, 206C) einer aus einer Vielzahl von Teilchenvalidierungsschaltkreisen (206A, 206B, 206C) ist, wobei jeder aus der Vielzahl von Teilchenvalidierungsschaltkreisen (206A, 206B, 202C) durch eine entsprechende leitfähige Durchkontaktierung (304) mit einem entsprechenden aus der Vielzahl von Teilchenerfassungsschaltkreisen (202A, 202B, 206C) verbunden ist.

10. Verfahren zum Betreiben eines integrierten Schaltkreises (10, 200) nach einem der Ansprüche 1 bis 9, wobei das Verfahren die folgenden Schritte umfasst:
mit einem Diodenschaltkreis des Teilchenerfassungsschaltkreises (202A, 202B, 202C), der in einem Substrat (203) unter mindestens einem Transistor (321) aus der Vielzahl von Transistoren (220, 221, 222; 321, 322) des integrierten Schaltkreises (10, 200) gebildet ist, Erkennen einer Ladung, die durch ein Teilchen erzeugt wird, das den integrierten Schaltkreis (10, 200) in dem N-Wannengebiet (305) des mindestens einen Transistors (321) durchquert; und
mit einer Überwachungsschaltung, die mit dem Teilchenerfassungsschaltkreis (202A, 202B, 202C) verbunden ist, Korrigieren eines Fehlerereignisses in dem integrierten Schaltkreis (10, 200), indem ermittelt wird, ob eine Spannungsstörung, die der Ladung zugehörig ist, die von dem Teilchenerfassungsschaltkreis (202A, 202B, 202C) erfasst wurde, größer als ein vorbestimmter Spannungsschwellenwert ist.

11. Verfahren nach Anspruch 10, das außerdem den folgenden Schritt umfasst:
mit dem Teilchenerfassungsschaltkreis (202A, 202B, 202C), Aufnehmen der Ladung, die von dem Teilchen erzeugt wurde, und Weiterleiten der aufgenommenen Ladung zu der Überwachungsschaltung.

12. Verfahren nach Anspruch 11, das außerdem den folgenden Schritt umfasst:
mit einem Sensorschaltkreis (206A), der mit dem Teilchenerfassungsschaltkreis (202A, 202B, 202C) verbunden ist, Erzeugen einer Spannungsstörungsausgabe aufgrund der Ladung, die mit dem Teilchenerfassungsschaltkreis (202A, 202B, 202C) von dem Teilchen aufgenommen wurde.

13. Verfahren nach Anspruch 12, das außerdem die folgenden Schritte umfasst:
mit dem Überwachungsschaltkreis (403), Empfangen der Spannungsstörungsausgabe; und
mit dem Überwachungsschaltkreis (403), Vergleichen der Spannungsstörungsausgabe mit dem vorbestimmten Spannungsschwellenwert.

14. Verfahren nach Anspruch 13, das außerdem den folgenden Schritt umfasst:
mit dem Überwachungsschaltkreis (403), Erzeugen eines Fehlerkorrektursignals, wenn die Spannungsstörungsausgabe den vorbestimmten Spannungsschwellenwert überschreitet.

15. Verfahren nach Anspruch 14, das außerdem die folgenden Schritte umfasst:
mit einem Fehlerprüfschaltkreis (405), Empfangen des Fehlerkorrektursignals;
mit dem Fehlerprüfschaltkreis (405), Aktivieren mindestens einer Fehlerkorrekturoperation in dem integrierten Schaltkreis (10, 200) aufgrund des Fehlerkorrektursignals; und
mit dem Fehlerprüfschaltkreis (405), Verringern einer Frequenz der mindestens einen Fehlerkorrekturoperation vor dem Erkennen der Ladung, die durch das Teilchen erzeugt wird, das den integrierten Schaltkreis (10, 200) durchquert.

## Revendications

1. Circuit intégré (10, 200) comprenant :
un substrat (203) ;
un circuit logique (18) qui comporte une pluralité de transistors (220, 221, 222 ; 321, 322) formés à une surface du substrat (203) ;
un circuit de détection de particules (202A, 202B, 202C) comprenant un circuit à diodes et formé à l'intérieur du substrat (203) au-dessous d'au moins un transistor (321) de la pluralité de transistors (220, 221, 222 ; 321, 322) ; et
un circuit de validation de particules (206A, 206B, 206C) configuré pour générer un signal de détection en réponse à la détection de la particule cosmique avec le circuit de détection de particules (202A, 202B, 202C) ;
**caractérisé en ce que**
le circuit à diodes est implanté dans le substrat (203) au-dessous d'une région de puits N (305) dudit au moins un transistor (321) et à l'intérieur d'une région d'implantation de type P (210) dans le substrat (203) qui entoure la région de puits N (305), et
dans lequel le circuit à diodes est configuré pour collecter une charge générée par une particule cosmique qui traverse le circuit logique (18) dans ladite région de puits N (305) dudit au moins un transistor (321).

2. Circuit intégré (10, 200) défini dans la revendication 1, dans lequel le circuit de détection de particules (202A, 202B, 202C) est formé à une profondeur d'environ 1 micromètre à 1,5 micromètre depuis une région de puits N (305).

3. Circuit intégré (10, 200) défini dans la revendication 1 ou 2, dans lequel le signal de détection est un signal de détection d'erreur.

4. Circuit intégré (10, 200) défini dans une des revendications 1 à 3, dans lequel le circuit de détection de particules (202A, 202B, 202C) est couplé électriquement aux circuits de validation de particules (206A, 206B, 206C) par un trou d'interconnexion conducteur (304).

5. Circuit intégré (10, 200) défini dans une des revendications 1 à 4, dans lequel le circuit de détection de particules (202A, 202B, 202C) a une taille, en coupe transversale du circuit intégré (10), de 1 µm en hauteur dans une direction verticale, 13 millimètres en longueur dans une direction horizontale, et 1 µm en largeur dans une direction perpendiculaire à la direction verticale et la direction horizontale.

6. Circuit intégré (10, 200) défini dans une des revendications 1 à 4, dans lequel le circuit de détection de particules (202A, 202B, 202C) a une taille, en coupe transversale du circuit intégré (10), de 1 µm en hauteur dans une direction verticale, 0,04 millimètre en longueur dans une direction horizontale, et 1 µm en largeur dans une direction perpendiculaire à la direction verticale et la direction horizontale.

7. Circuit intégré (10, 200) défini dans une des revendications 1 à 6, dans lequel les circuits de validation de particules (206A, 206B, 206C) comprend un amplificateur de détection.

8. Circuit intégré (10, 200) défini dans une des revendications 1 à 7, dans lequel le circuit de détection de particules (202A, 202B, 202C) est l'un d'une pluralité de circuits de détection de particules (202A, 202B, 202C), dont chacun est agencé pour détecter un emplacement de la particule cosmique à l'intérieur du circuit intégré (10, 200).

9. Circuit intégré (10, 200) défini dans la revendication 8, dans lequel les circuits de validation de particules (206A, 206B, 206C) est l'un d'une pluralité de circuits de validation de particules (206A, 206B, 206C), chaque circuit de la pluralité de circuits de validation de particules (206A, 206B, 206C) étant couplé à un circuit correspondant de la pluralité de circuits de détection de particules (202A, 202B, 202C) par un trou d'interconnexion conducteur correspondant (304).

10. Procédé de fonctionnement d'un circuit intégré (10, 200) selon une des revendications 1 à 9, le procédé comprenant les étapes consistant à :
avec un circuit à diodes du circuit de détection de particules (202A, 202B, 202C) formé à l'intérieur du substrat (203) au-dessous d'au moins un transistor (321) de la pluralité de transistors (220, 221, 222 ; 321, 322) du circuit intégré (10, 200), détecter une charge générée par une particule traversant le circuit intégré (10, 200) dans ladite région de puits N (305) dudit au moins un transistor (321) ; et
avec un circuit de surveillance couplé au circuit de détection de particules (202A, 202B, 202C), corriger un événement d'erreur dans le circuit intégré (10, 200) en déterminant si une perturbation de tension associée à la charge détectée par le circuit de détection de particules (202A, 202B, 202C) est supérieure à un seuil de tension prédéterminé.

11. Procédé défini dans la revendication 10, comprenant en outre l'étape consistant à :
avec le circuit de détection de particules (202A, 202B, 202C), collecter la charge générée par la particule et transférer la charge collectée au circuit de surveillance.

12. Procédé défini dans la revendication 11, comprenant en outre l'étape consistant à :
avec un circuit de détection (206A) couplé au circuit de détection de particules (202A, 202B, 202C), générer une sortie de perturbation de tension basée sur la charge collectée par le circuit de détection de particules (202A, 202B, 202C) à partir de la particule.

13. Procédé défini dans la revendication 12, comprenant en outre les étapes consistant à :
avec le circuit de surveillance (403), recevoir la sortie de perturbation de tension ; et
avec le circuit de surveillance (403), comparer la sortie de perturbation de tension au seuil de tension prédéterminé.

14. Procédé défini dans la revendication 13, comprenant en outre l'étape consistant à :
avec le circuit de surveillance (403), générer un signal de correction d'erreur quand la sortie de perturbation de tension dépasse le seuil de tension prédéterminé.

15. Procédé défini dans la revendication 14, comprenant en outre les étapes consistant à :
avec un circuit de vérification d'erreur (405), recevoir le signal de correction d'erreur ;
avec le circuit de vérification d'erreur (405), activer au moins une opération de correction d'erreur dans le circuit intégré (10, 200) sur la base du signal de correction d'erreur ; et
avec le circuit de vérification d'erreur (405), réduire une fréquence de l'au moins une opération de vérification d'erreur avant de détecter la charge générée par la particule traversant le circuit intégré (10, 200).
